# EUROPÄISCHE PATENTANMELDUNG

(11) **EP 1 143 456 A2**
(43) Veröffentlichungstag der Anmeldung: **10.10.2001**
(21) Anmeldenummer: 01107280.8
(22) Anmeldetag: 23.03.2001
(51) Int. Cl.: G11C 29/00

(54) **Integrierter Speicher und Verfahren zur Funktionsüberprüfung von Speicherzellen eines integrierten Speichers**

(30) Priorität: 04.04.2000 DE 10016719
(71) Anmelder: Infineon Technologies AG, 81669 München (DE)
(72) Erfinder: Daehn, Wilfried, Dr., 29277 Celle (DE); Helfer, Wolfgang, 80807 München (DE)
(74) Vertreter: Epping Hermann & Fischer

(57) **Zusammenfassung**

Es wird ein integrierter Speicher beschrieben, der adressierbare Speicherzellen (MC) zusammengefaßt in Gruppen von Spaltenleitungen (C) und Reihenleitungen (R) aufweist. Die Adressen (CADR, RADR) der Speicherzellen umfassen jeweils einen ersten Adreßteil (CADR1, RADR1), über den die jeweiligen Gruppen von Spaltenleitungen (C) und Reihenleitungen (R) adressierbar sind. Die Speicherzellen (MC) werden in einem Verfahren zur Funktionsüberprüfung im Kreuzungsbereich (K) zweier Gruppen (C, R) nacheinander auf Fehlerfreiheit geprüft. Im Anschluß daran werden Speicherzellen (MC) einer weiteren Gruppe (C, R) geprüft. Bei Übereinstimmung von miteinander verglichenen ersten Adreßteilen (CADR1, RADR1) von fehlerhaften Speicherzellen wird die Adresse wenigstens einer der fehlerhaften Speicherzellen zur Auswertung weiterverarbeitet, die Adressen weiterer fehlerhafter Speicherzellen werden nicht weiterverarbeitet. Dadurch ist eine weitgehende Kompaktierung von Adressen fehlerhafter Speicherzellen ermöglicht.

## Beschreibung

Die vorliegende Erfindung betrifft einen integrierten Speicher, der einem Speicherzellentest unterziehbar ist zur Ermittlung von funktionsfähigen und fehlerhaften Speicherzellen, der adressierbare Speicherzellen aufweist, die in einem matrixförmigen Speicherzellenfeld entlang von Spaltenleitungen und Reihenleitungen angeordnet sind, und die zu Gruppen von Spaltenleitungen und Reihenleitungen zusammengefaßt sind, sowie ein Verfahren zur Funktionsüberprüfung von Speicherzellen eines solchen Speichers.

Zur Überprüfung von Speicherzellen eines integrierten Speichers hinsichtlich deren Funktionsfähigkeit wird dieser im allgemeinen einem Speicherzellentest unterzogen. Während eines solchen Testbetriebs zur Überprüfung von Speicherzellen werden beispielsweise Testdaten in jede einzelne Speicherzelle eingeschrieben und wieder ausgelesen. Ein Vergleich zwischen den eingeschriebenen und wieder ausgelesenen Daten gibt Aufschluß darüber, ob ein Funktionsfehler einer geprüften Speicherzelle vorliegt.

Üblicherweise weisen integrierte Speicher Speicherzellen auf, die in einem matrixförmigen Speicherzellenfeld entlang von Spaltenleitungen und Reihenleitungen angeordnet sind. Die Speicherzellen sind dabei beispielsweise zu Gruppen von Spaltenleitungen und Reihenleitungen zusammengefaßt. Übliche Redundanzkonzepte zur Reparatur von Halbleiterspeichern sehen vor, daß bei einem Defekt einer Speicherzelle oder eines Speicherwortes, das eine Gruppe von Speicherzellen umfaßt, stets eine Gruppe von Spaltenleitungen oder Reihenleitungen des Speicherzellenfeldes ausgetauscht werden. Hinsichtlich einer zu wählenden Reihen- oder Spaltenreparatur sind die im Kreuzungsbereich einer Gruppe von Reihenleitungen und einer Gruppe von Spaltenleitungen befindlichen Speicherzellen bzw. Speicherworte äquivalent. D.h. eine Reparatur dieser Speicherzellen kann durch eine Gruppe von redundanten Spaltenleitungen oder durch eine Gruppe redundanten Reihenleitungen erfolgen.

Eine Reparatur wird ausgelöst, wenn eine oder mehrere beliebige Speicherzellen bzw. Speicherworte im Kreuzungsbereich ausfallen. Zur Ableitung der Reparaturinformation werden beispielsweise die Adressen der fehlerhaften Speicherzellen bzw. die Adressen fehlerhafter Speicherworte, auch als Fehleradressen bezeichnet, gespeichert und zur Auswertung weiterverarbeitet.

Eine externe Prüfeinrichtung oder eine Selbsttesteinheit prüft den Speicherbaustein, indem in einer bestimmten Adreßreihenfolge wechselweise Daten in die Speicherzellen des Bausteins eingeschrieben oder ausgelesen werden, und dabei mit erwarteten Daten verglichen werden. Einem Adreßgenerator kommt dabei die Aufgabe der Generierung der jeweiligen Adressen für die Schreib- oder Leseoperationen zu. Die bei jeder einhergehenden Vergleichsoperation anfallende Fehlerinformation kann auf einfache Weise akkumuliert werden. Beispielsweise wird, sobald ein Fehler aufgetreten ist, ein sogenanntes Fehlerflag gesetzt, welches den Baustein als defekt kennzeichnet. Soll der Baustein jedoch repariert werden, ist die Information darüber, welche Speicherzelle defekt ist, an eine Redundanzanalyseeinheit auf dem Baustein oder außerhalb desselben weiterzuleiten. Aus diesen Fehlerdaten wird die Reparaturinformation abgeleitet. Um die hierfür erforderliche Übertragungszeit oder Kanalkapazität bzw. Signalbreite des zu übertragenden Signals gering zu halten, ist es zweckmäßig, daß die Fehlerdaten beispielsweise in Form von Fehleradressen zuvor unter Berücksichtigung des Redundanzkonzeptes des Speicherbausteins komprimiert werden.

Die Aufgabe der vorliegenden Erfindung ist es, ein Verfahren zur Funktionsüberprüfung von Speicherzellen eines eingangs genannten integrierten Speichers anzugeben, durch das eine weitgehende Kompaktierung von Adressen fehlerhafter Speicherzellen ermöglicht ist.

Weiterhin ist es Aufgabe der vorliegenden Erfindung, einen integrierten Speicher der eingangs genannten Art anzugeben, durch den bei der Durchführung eines Verfahrens zur Funktionsüberprüfung von Speicherzellen eine weitgehende Kompaktierung von Adressen fehlerhafter Speicherzellen ermöglicht ist.

Die Aufgabe betreffend das Verfahren wird gelöst durch ein Verfahren zur Funktionsüberprüfung von Speicherzellen eines integrierten Speichers der eingangs genannten Art, bei dem die Speicherzellen jeweils über Spaltenadressen und Reihenadressen adressierbar sind, und bei dem die Spaltenadressen und Reihenadressen der Speicherzellen jeweils einen ersten Adreßteil umfassen, über den die jeweiligen Gruppen von Spaltenleitungen und Reihenleitungen adressierbar sind, mit den Merkmalen:
- es werden Speicherzellen im Kreuzungsbereich einer der Gruppen von Spaltenleitungen und einer der Gruppen von Reihenleitungen nacheinander auf Fehlerfreiheit geprüft, im Anschluß daran werden Speicherzellen einer weiteren Gruppe von Spaltenleitungen oder Reihenleitungen geprüft,
- es wird ein Vergleich zwischen jeweiligen ersten Adreßteilen der Speicherzellen durchgeführt, die als fehlerhaft erkannt sind,
- bei Übereinstimmung der jeweiligen ersten Adreßteile von fehlerhaften Speicherzellen wird die Adresse wenigstens einer der fehlerhaften Speicherzellen als Ergebnis der Funktionsüberprüfung zur Auswertung weiterverarbeitet, die Adressen weiterer fehlerhafter Speicherzellen werden nicht weiterverarbeitet.

Die Aufgabe betreffend den integrierten Speicher wird gelöst durch einen integrierten Speicher der eingangs genannten Art, bei dem die Speicherzellen jeweils über Spaltenadressen und Reihenadressen adressierbar sind; bei dem die Spaltenadressen und Reihenadressen jeweils einen ersten Adreßteil umfassen, über den die jeweiligen Gruppen von Spaltenleitungen und Reihenleitungen adressierbar sind, und einen zweiten Adreßteil, über den die Speicherzellen innerhalb der jeweiligen Gruppe adressierbar sind; mit einer Adressierungseinheit zur Adressierung von zu prüfenden Speicherzellen; mit einem jeweiligen Zähler zur Generierung des ersten Adreßteils und einem jeweiligen weiteren Zähler zur Generierung des zweiten Adreßteils, die jeweils Steuereingänge aufweisen, die mit Ausgängen der Adressierungseinheit verbunden sind; bei dem die jeweiligen Adreßteile der zu prüfenden Speicherzellen ausgangsseitig an dem jeweiligen Zähler entnehmbar sind.

Speicherzellen bzw. Speicherworte (Gruppen von Speicherzellen) aus dem gleichen Kreuzungsbereich zeichnen sich dadurch aus, daß sie mit Ausnahme der die Position innerhalb der jeweiligen Gruppe bestimmenden niederwertigen Reihen- und Spaltenadreßbits (zweiter Adreßteil) identische Reihen- und Spaltenadressen aufweisen (erster Adreßteil). Die Adressen fehlerhafter Speicherzellen bzw. Speicherworte (Fehleradressen) können hier komprimiert werden, indem aufeinanderfolgende Fehleradressen bzw. deren erste Adreßteile miteinander verglichen werden und beispielsweise die zweite und weitere Fehleradressen nicht mehr an eine Redundanzanalyseeinheit weitergegeben werden, wenn sie zum gleichen Kreuzungsbereich einer Gruppe von Spaltenleitungen und einer Gruppe von Reihenleitungen gehören wie die zuerst aufgetretene Fehleradresse.

Eine Fehleradresse wird dabei als Ergebnis der Funktionsüberprüfung zur Auswertung weiterverarbeitet. Das Ergebnis kann beispielsweise als sogenannte Pass-Fail-Information gewertet werden. Außerdem ist es möglich festzustellen, welche der Speicherzellen fehlerhaft sind. Dies kann als Information für eine spätere Reparatur des Speichers herangezogen werden.

Für diesen Fall sieht dabei ein nach dem Funktionstest angewandtes Redundanzkonzept vor, daß bei einem Defekt einer Speicherzelle oder eines Speicherwortes stets eine Gruppe von Spaltenleitungen oder eine Gruppe von Reihenleitungen ausgetauscht wird. Eine Reparatur wird ausgelöst, wenn eine oder mehrere beliebige Speicherzellen in dem betreffenden Kreuzungsbereich defekt sind. Das bedeutet, für eine spätere Reparatur wird die Information über weitere defekte Speicherzellen in einem zu prüfenden Kreuzungsbereich nicht benötigt, da das Vorhandensein bereits einer defekten Speicherzelle ausreicht, um eine Reparatur auszulösen.

In einer Weiterbildung des erfindungsgemäßen Verfahrens werden innerhalb des Kreuzungsbereichs einer der Gruppen von Spaltenleitungen und einer der Gruppen von Reihenleitungen die Speicherzellen nacheinander entlang von Spaltenleitungen oder Reihenleitungen geprüft.

In einer weiteren Ausführungsform des Verfahrens wird zur Prüfung der Speicherzellen innerhalb des Kreuzungsbereichs zuerst der zweite Adreßteil der Spaltenadresse und nach vollständiger Prüfung der betreffenden Reihenleitung der zweite Adreßteil der Reihenadresse inkrementiert. Zur Ermittlung der als nächstes zu prüfenden Gruppe wird der erste Adreßteil der Spaltenadresse inkrementiert. Das bedeutet, es wird innerhalb des Kreuzungsbereichs lokal entlang von Reihenleitungen geprüft, wobei die Reihenleitungen innerhalb des Kreuzungsbereichs nacheinander abgearbeitet werden. Danach wird mit der nächsten Gruppe von Spaltenleitungen fortgefahren.

Durch Änderung der Adressierreihenfolge wird entsprechend in einer anderen Ausführung des Verfahrens zur Prüfung der Speicherzellen innerhalb des Kreuzungsbereichs zuerst der zweite Adreßteil der Spaltenadresse und nach vollständiger Prüfung der betreffenden Reihenleitung der zweite Adreßteil der Reihenadresse inkrementiert, wobei zur Ermittlung der als nächstes zu prüfenden Gruppe der erste Adreßteil der Reihenadresse inkrementiert wird. D.h. es wird innerhalb des Kreuzungsbereichs lokal in der gleichen Reihenfolge adressiert wie in der zuvor beschriebenen Ausführung des Verfahrens, als nächste zu prüfende Gruppe wird jedoch die nächste Gruppe von Reihenleitungen adressiert.

In einer anderen Ausführungsform des Verfahrens wird zur Prüfung der Speicherzellen innerhalb des Kreuzungsbereichs zuerst der zweite Adreßteil der Reihenadresse und nach vollständiger Prüfung der betreffenden Spaltenleitung der zweite Adreßteil der Spaltenadresse inkrementiert. Zur Ermittlung der als nächsten zu prüfenden Gruppe wird der erste Adreßteil der Spaltenadresse inkrementiert.

In einer anderen Ausführungsform des Verfahrens wird zur Prüfung der Speicherzellen innerhalb des Kreuzungsbereichs zuerst der zweite Adreßteil der Reihenadresse und nach vollständiger Prüfung der betreffenden Spaltenleitung der zweite Adreßteil der Spaltenadresse inkrementiert, zur Ermittlung der als nächstes zu prüfenden Gruppe wird der erste Adreßteil der Reihenadresse inkrementiert.

Die Adressierungseinheit des erfindungsgemäßen Speichers ist derart ausgeführt, daß die Generierung der Adressen der Speicherzellen in der beschriebenen Reihenfolge ermöglicht ist. Die Adressen der Speicherzellen, die jeweils in einen ersten Adreßteil und zweiten Adreßteil aufgespalten sind, werden von separaten kooperierenden Zählern generiert. Die jeweiligen Zähler werden dabei von der Adressierungseinheit in geeigneter Weise angesteuert. Die jeweiligen Adreßteile der Speicherzellen sind ausgangsseitig an den jeweiligen Zählern zu entnehmen.

In einer vorteilhaften Ausführungsform weist der Speicher einen ersten Zähler auf zur Generierung des ersten Adreßteils der Reihenadresse, einen zweiten Zähler zur Generierung des zweiten Adreßteils der Reihenadresse, einen dritten Zähler zur Generierung des ersten Adreßteils der Spaltenadresse sowie einen vierten Zähler zur Generierung des zweiten Adreßteils der Spaltenadresse. Mit dieser Anordnung werden die jeweiligen Adreßteile der Spaltenadresse und Reihenadresse, gesteuert von der Adressierungseinheit, unabhängig voneinander erzeugt.

In einer anderen Ausführungsform des integrierten Speichers weist dieser einen ersten Zähler zur Generierung des ersten Adreßteils der Reihenadresse und Spaltenadresse und einen zweiten Zähler zur Generierung des zweiten Adreßteils der Reihenadresse und Spaltenadresse auf.

Für die verwendeten Zähler kann jede Ausprägung eines endlichen Automaten zum Einsatz kommen, sofern sichergestellt ist, daß der Automat durch alle möglichen Zustände und damit durch alle Teiladressen läuft. Hierzu zählen insbesondere lineare Zähler, Gray-Code-Zähler oder rückgekoppelte Schieberegister sowie spezielle Formen zellularer Automaten.

Zur Durchführung der beschriebenen unterschiedlichen Ausführungsformen des Verfahrens ist die Adressierungseinheit vorteilhaft jeweils in einer von mehreren einstellbaren Betriebsarten betreibbar. Diese unterscheiden sich in der Adressierungsreihenfolge der zu prüfenden Speicherzellen.

Weitere vorteilhafte Aus- und Weiterbildungen sind Gegenstand abhängiger Ansprüche.

Die Erfindung wird im folgenden anhand der in der Zeichnung dargestellten Figuren, die Ausführungsbeispiele darstellen, näher erläutert. Es zeigen:
- Figur 1: eine schematische Darstellung eines matrixförmigen Speicherzellenfeldes eines integrierten Speichers,
- Figur 2: eine weitere Darstellung des Speicherzellenfeldes mit Gruppen von Spaltenleitungen und Reihenleitungen,
- Figuren 3a-d: schematische Darstellungen der Adressierreihenfolgen von Ausführungsformen des erfindungsgemäßen Verfahrens,
- Figuren 4 bis 7: Ausführungsformen des erfindungsgemäßen Speichers.

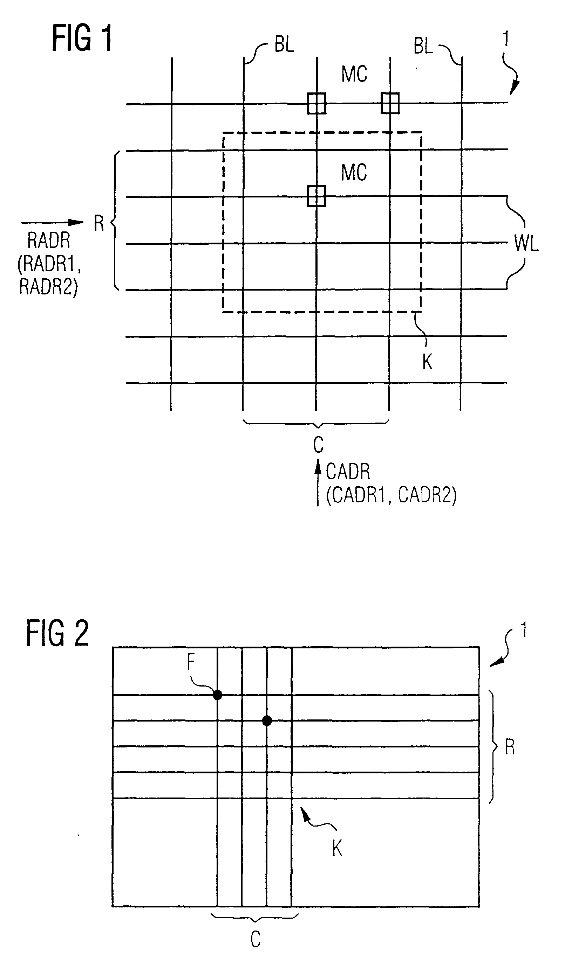

Figur 1 ist ein matrixförmig organisiertes Speicherzellenfeld 1 beispielsweise eines DRAM zu entnehmen, das Reihen- bzw. Wortleitungen WL und Spalten- bzw. Bitleitungen BL aufweist, in deren Kreuzungspunkten Speicherzellen MC angeordnet sind. Die Speicherzellen MC des hier gezeigten Speichers beinhalten jeweils einen Auswahltransistor und einen Speicherkondensator. Dabei sind Steuereingänge der Auswahltransistoren mit einer der Wortleitung WL verbunden, während ein Hauptstrompfad der Auswahltransistoren zwischen dem Speicherkondensator der jeweiligen Speicherzelle MC und einer der Bitleitungen BL angeordnet ist. Die Reihenleitungen WL und Spaltenleitungen BL sind dabei zu Gruppen von Reihenleitungen R bzw. Gruppen von Spaltenleitungen C zusammengefaßt. Die Gruppe von Reihenleitungen R (Reihengruppe) und die Gruppe von Spaltenleitungen C (Spaltengruppe) kreuzen sich im Kreuzungsbereich K.

Die Speicherzellen MC sind jeweils über Spaltenadressen CADR und Reihenadressen RADR adressierbar. Die Spaltenadressen CADR und Reihenadressen RADR der Speicherzellen MC weisen jeweils einen ersten Adreßteil CADR1, RADR1 auf, über den die jeweilige Spaltengruppe C bzw. Reihengruppe R adressierbar ist. Die Adressen weisen außerdem einen zweiten Adreßteil CADR2, RADR2 auf, über den die Speicherzellen MC innerhalb der jeweiligen Gruppen C bzw. R adressierbar sind.

Im Zuge der Funktionsüberprüfung der Speicherzellen MC im Kreuzungsbereich K werden die Speicherzellen MC nacheinander auf Fehlerfreiheit geprüft. Dabei können im Kreuzungsbereich K Fehler auftreten, welche durch eine unterschiedliche Position sowohl in Spalten- als auch in Reihenrichtung gekennzeichnet sind. Diese Fehler sind als Fehlerorte F in Figur 2 dargestellt. Die Speicherzellen MC im Kreuzungsbereich K zeichnen sich dadurch aus, daß deren Adressen in ihren ersten Adreßteilen RADR1 bzw. CADR1 übereinstimmen. Durch die Aufspaltung der Adressen der Speicherzellen MC in einen ersten Adreßteil und einen zweiten Adreßteil werden die Adressen der Speicherzellen MC jeweils in eine sogenannte globale und in eine sogenannte lokale Teiladresse aufgespalten. Die globale Reihen-/Spaltenadresse RADR1 bzw. CADR1 ist die Adresse der ersetzbaren Reihen-/Spaltengruppe R bzw. C im Speicherzellenfeld 1. Die lokale Reihen-/Spaltenadresse RADR2 bzw. CADR2 bestimmt die Position der adressierten Speicherzelle bzw. des adressierten Speicherwortes innerhalb der jeweiligen Reihen-/Spaltengruppe R bzw. C. Dies ermöglicht zunächst alle Zellen im Kreuzungsbereich K einer Reihen- und Spaltengruppe zu testen, bevor in Reihen- oder Spaltenrichtung mit der nächsten Gruppe durch Ändern der globalen Reihen- oder Spaltenadresse fortgefahren wird.

Es werden dabei zuerst alle Speicherzellen MC bzw. Speicherworte im Kreuzungsbereich K der Reihengruppe R und Spaltengruppe C geprüft. Dabei kann eine Komprimierung der Adressen fehlerhafter Speicherzellen MC in dem Kreuzungsbereich K durch den Vergleich der globalen Reihenadresse RADR1 und Spaltenadresse CADR1 aufeinanderfolgender Fehleradressen geschehen. Haben mehrere aufeinanderfolgende Fehleradressen eine gleiche globale Reihenadresse RADR1 und Spaltenadresse CADR1, wird nur beispielsweise die erste Fehleradresse an eine Redundanzanalyseeinheit weitergegeben, die sich beispielsweise außerhalb des integrierten Speichers befindet. Die Adressen weiterer fehlerhafter Speicherzellen werden nicht zur Auswertung weiterverarbeitet. Da alle Speicherzellen MC mit gleicher globaler Reihenadresse RADR1 und Spaltenadresse CADR1 unmittelbar hintereinander geprüft werden, erfolgt die Kompaktierung über alle Fehleradressen im Kreuzungsbereich K der Reihengruppe R und Spaltengruppe C. Da Fehler mit unterschiedlichen Spalten- und Reihenadressen komprimiert werden, erfolgt die Kompaktierung zweidimensional, im Gegensatz zu einer eindimensionalen Kompaktierung, bei der nur Fehleradressen mit gleicher Spalten- oder Reihenadresse komprimiert werden.

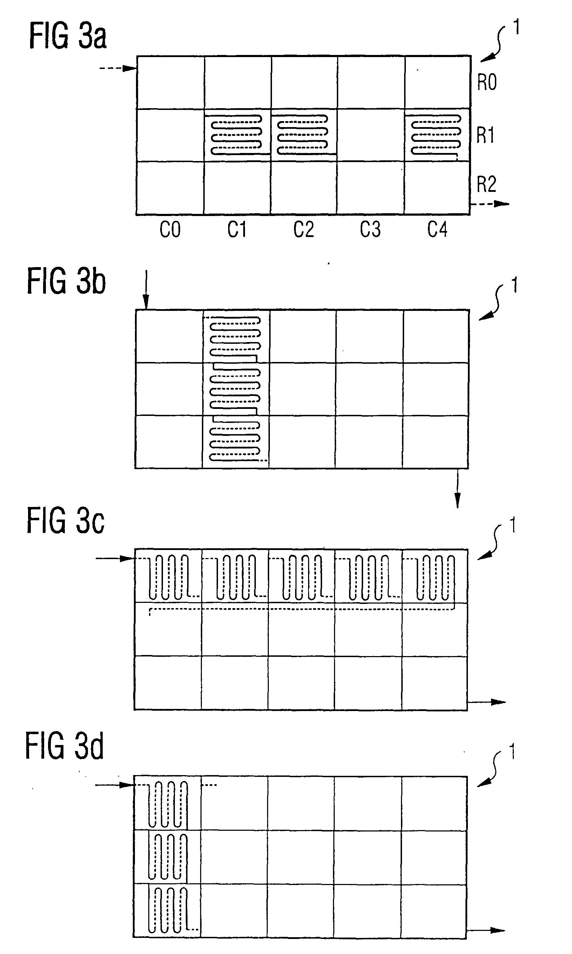

Beispielhaft an Figur 3a wird der Adressierungsablauf während einer Funktionsprüfung erläutert. Es werden die Speicherzellen im Kreuzungsbereich der Gruppen R1 und C1 geprüft. Es wird zuerst die lokale Spaltenadresse CADR2 erhöht und, nach vollständiger Prüfung der betreffenden Reihe, die lokale Reihenadresse RADR2 erhöht, bis sämtliche Speicherzellen im Kreuzungsbereich geprüft sind. Als nächste zu prüfende Gruppe wird der Kreuzungsbereich der Gruppen R1 und C2 geprüft. Es wird also die globale Spaltenadresse CADR1 erhöht.

Die Richtungspräferenz der Adressierreihenfolge kann dabei lokal und global unabhängig festgelegt werden. Die unterschiedlichen Adressierreihenfolgen sind in den Figuren 3a bis 3d schematisch dargestellt. Es wird dabei eine unterschiedliche Priorisierung bei der Teiladressgenerierung durchgeführt. Die unterschiedlichen Priorisierungen bei der Teiladressgenerierung sind entsprechend den Figuren 3a bis 3d in der folgenden Tabelle aufgelistet.

**Tabelle:**

| Priorisierung bei der Teiladreßgenerierung (1 = zeitlich zuerst, 4 = zeitlich zuletzt) | | | | | |
|---|---|---|---|---|---|
| Figur | Reihenadresse | | Spaltenadresse | | Inkrement |
| | RADR1 | RADR2 | CADR1 | CADR2 | |
| 3a | 4 | 2 | 3 | 1 | lokal CADR zuerst, global CADR zuerst |
| 3b | 3 | 2 | 4 | 1 | lokal CADR zuerst, global RADR zuerst |
| 3c | 4 | 1 | 3 | 2 | lokal RADR zuerst, global CADR zuerst |
| 3d | 3 | 1 | 4 | 2 | lokal RADR zuerst, global RADR zuerst |

Ein für die Reparatur des integrierten Speichers einsetzbares Redundanzkonzept sieht vor, daß bei einem Defekt einer Speicherzelle MC stets eine Spaltengruppe C oder Reihengruppe R des Speicherzellenfeldes 1 ausgetauscht wird. Eine Reparatur wird dabei ausgelöst, wenn eine oder mehrere beliebige Speicherzellen MC im Kreuzungsbereich K ausfallen. Dadurch ist es für eine spätere Reparatur nicht mehr relevant, daß nach der Feststellung einer fehlerhaften Speicherzelle Adressen von weiteren fehlerhaften Speicherzellen an die Redundanzanalyseeinheit weitergegeben werden, wenn sie zum gleichen Kreuzungsbereich K gehören.

Um bei einer Funktionsüberprüfung, die die Übertragung großer Datenmengen erfordern kann, in der Datenübertragungsrate nicht durch die Anzahl der zur Verfügung stehenden Anschlüsse des Speichers beschränkt zu sein, ist es üblich, eine die Funktionsüberprüfung durchführende Selbsttesteinheit auf derselben integrierten Schaltung vorzusehen, auf der sich der Speicher befindet. Eine derartige Realisierung wird auch als "Built-In Self Test" (BIST) bezeichnet.

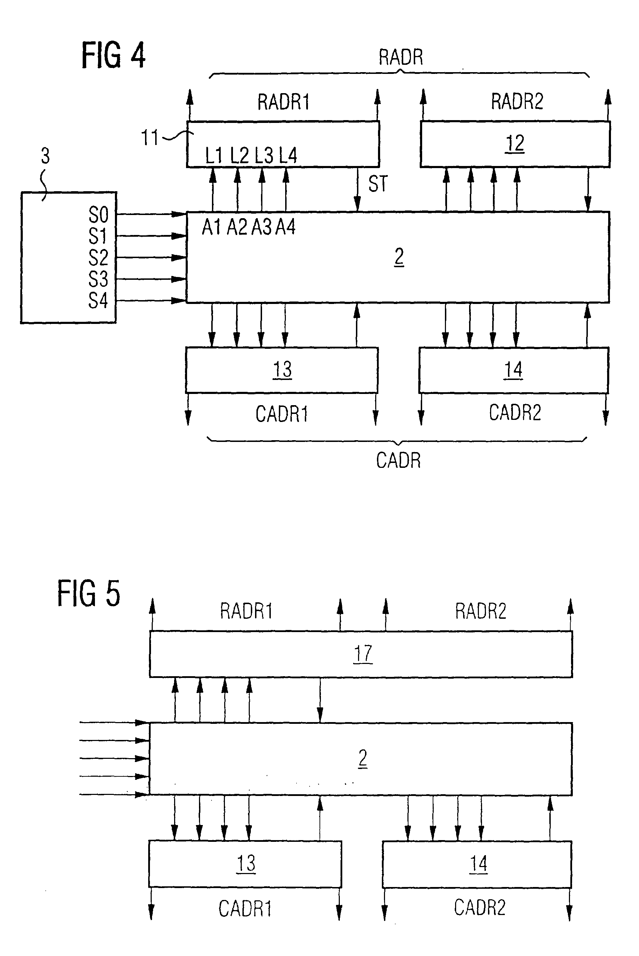

In den Figuren 4 - 7 sind Ausführungsformen eines erfindungsgemäßen Speichers dargestellt. Die Ausführungsbeispiele weisen jeweils eine Adressierungseinheit 2 auf zur Adressierung von zu prüfenden Speicherzellen MC. An die jeweilige Adressierungseinheit 2 sind Zähler 11 bis 18 angeschlossen, die jeweils Steuereingänge L1 bis L4 aufweisen, die mit Ausgängen A1 bis A4 der Adressierungseinheit 2 verbunden sind. Außerdem weist jeder der Zähler 11 bis 18 ein Statussignal ST auf, das an die Adressierungseinheit 2 zurückgegeben wird. Die jeweiligen Adreßteile der Adressen RADR und CADR der zu prüfenden Speicherzellen MC sind ausgangsseitig an den jeweiligen Zählern 11 bis 18 entnehmbar.

Die Adressierungseinheit 2 ist außerdem mit einer Selbsttesteinheit 3 verbunden, die Steueranschlüsse S0 bis S4 aufweist zur Steuerung der Adressierungsvorgänge. Am Steueranschluß S0 liegt beispielsweise ein Signal zur Einstellung einer Adressierungsreihenfolge gemäß den Figuren 3a bis 3d an. Die Adressierungseinheit 2 ist also jeweils in einer von mehreren einstellbaren Betriebsarten betreibbar, die sich in der Adressierungsreihenfolge der zu prüfenden Speicherzellen MC unterscheiden. Am Steueranschluß S1 liegt ein "Hold"-Signal an, das dem jeweiligen Zähler anzeigt, einen bestimmten Wert beizubehalten. Über den Steueranschluß S2 kann eingestellt werden, ob der jeweilige Zähler in aufsteigender oder absteigender Reihenfolge zählt. Die Steueranschlüsse S3 und S4 sind Anschlüsse für Set- bzw. Reset-Signale. Die jeweiligen Signale an den Steueranschlüssen S1 bis S4 werden, gesteuert durch die Adressierungseinheit 2, an die jeweiligen Ausgänge A1 bis A4 der Adressierungseinheit 2 weitergeleitet.

Durch die Adressierungseinheit 2 werden folglich die Zähler 11 bis 18 derart angesteuert, daß die Speicherzellen MC im Kreuzungsbereich K einer Spaltengruppe C und einer Reihengruppe R nacheinander adressierbar sind, und im Anschluß daran Speicherzellen MC einer weiteren Spaltengruppe C oder Reihengruppe R adressierbar sind.

In Figur 4 weist der integrierte Speicher einen Zähler 11 zur Generierung des ersten Adreßteils der Reihenadresse RADR1, einen Zähler 12 zur Generierung des zweiten Adreßteils der Reihenadresse RADR2, einen Zähler 13 zur Generierung des ersten Adreßteils der Spaltenadresse CADR1 und einen Zähler 14 zur Generierung des zweiten Adreßteils der Spaltenadresse CADR2 auf.

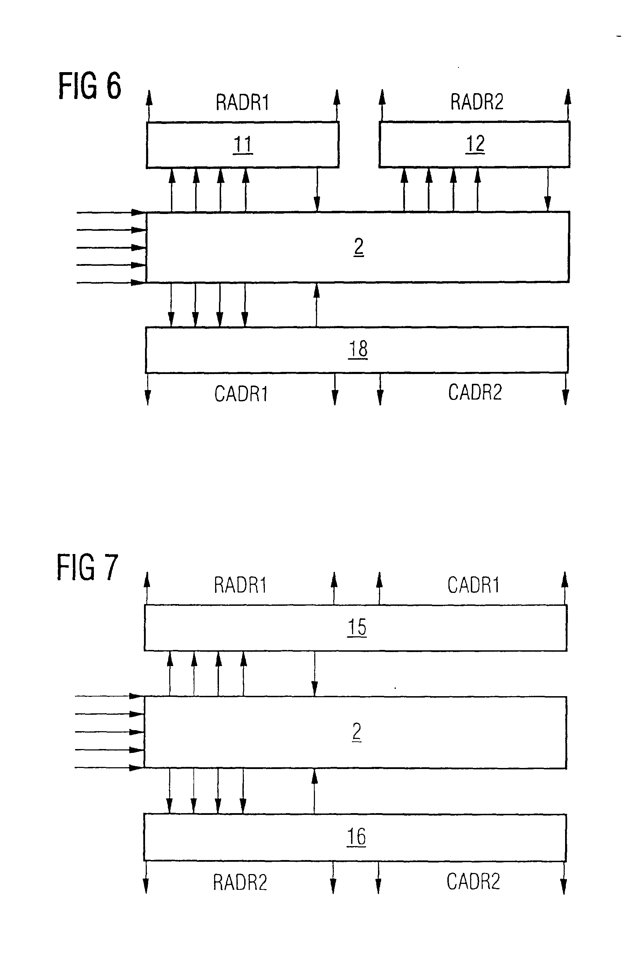

Werden die Adressierungsmodi der Figuren 3c und 3d ausgeschlossen, so vereinfacht sich die Anordnung nach Figur 4 gemäß der Anordnung nach Figur 5. Dort sind die Reihenadreßzähler 11 und 12 zu einem gemeinsamen Reihenadreßzähler 17 zusammengefaßt. An dem Reihenadreßzähler 17 sind jeweils die ersten und zweiten Adreßteile RADR1 und RADR2 der Reihenadresse zu entnehmen.

Werden die Adressierungsmodi gemäß den Figuren 3a und 3b ausgeschlossen, so vereinfacht sich die Anordnung nach Figur 4 zu der Anordnung gemäß Figur 6. Dort sind die Spaltenadreßzähler 13 und 14 zu einem gemeinsamen Spaltenadreßzähler 18 zusammengefaßt. An dem Spaltenadreßzähler 18 sind jeweils die ersten Adreßteile und zweiten Adreßteile CADR1 und CADR2 der Spaltenadresse zu entnehmen.

Gemäß der Anordnung nach Figur 7 weist der integrierte Speicher einen Zähler 15 zur Generierung des ersten Adreßteils RADR1 bzw. CADR1 der Reihenadresse und Spaltenadresse auf, sowie einen Zähler 16 zur Generierung des zweiten Adreßteils RADR2 bzw. CADR2 der Reihenadresse und Spaltenadresse. Die Zähler 15 und 16 bezeichnen also einen sogenannten globalen Adreßzähler 15 bzw. einen sogenannten lokalen Adreßzähler 16, an dem die jeweiligen Reihen- und Spaltenadressen entnehmbar sind.

Das zuvor beschriebene erfindungsgemäße Verfahren zur Funktionsüberprüfung von Speicherzellen kann mit dem beschriebenen erfindungsgemäßen integrierten Speicher bzw. den dargestellten Ausführungsbeispielen des integrierten Speichers durchgeführt werden. Die Steuereingänge der Adressierungseinheit 2 sind dazu beispielsweise mit einem Microcontroller des integrierten Speichers verbunden, der den Funktionstest, beispielsweise von extern gesteuert, durchführt. In einer anderen Ausführungsform sind die Steuereingänge der Adressierungseinheit 2 mit einer Selbsttesteinheit 3 des integrierten Speichers verbunden, wie oben beschrieben. Es sind jedoch auch Lösungen denkbar, bei denen die Speicherzellen, die gemäß dem erfindungsgemäßen Verfahren geprüft werden, direkt von beispielsweise dem Microcontroller adressiert werden. Bei diesen Lösungen ist also keine Adressierungseinheit 2 zur Steuerung einer Adressierungsreihenfolge bei der Durchführung eines Funktionstests notwendig.

## Patentansprüche

1. Verfahren zur Funktionsüberprüfung von Speicherzellen eines integrierten Speichers,
- der adressierbare Speicherzellen (MC) in einem matrixförmigen Speicherzellenfeld (1) entlang von Spaltenleitungen (BL) und Reihenleitungen (WL) aufweist,
- bei dem die Speicherzellen (MC) zu Gruppen von Spaltenleitungen (C) und Reihenleitungen (R) zusammengefaßt sind und jeweils über Spaltenadressen (CADR) und Reihenadressen (RADR) adressierbar sind,
- bei dem die Spaltenadressen (CADR) und Reihenadressen (RADR) der Speicherzellen jeweils einen ersten Adreßteil (CADR1, RADR1) umfassen, über den die jeweiligen Gruppen von Spaltenleitungen (C) und Reihenleitungen (R) adressierbar sind,
mit den Merkmalen:
- es werden die Speicherzellen (MC) im Kreuzungsbereich (K) einer der Gruppen von Spaltenleitungen (C) und einer der Gruppen von Reihenleitungen (R) nacheinander auf Fehlerfreiheit geprüft, im Anschluß daran werden Speicherzellen (MC) einer weiteren Gruppe von Spaltenleitungen (C) oder Reihenleitungen (R) geprüft,
- es wird ein Vergleich zwischen jeweiligen ersten Adreßteilen (CADR1, RADR1) der Speicherzellen durchgeführt, die als fehlerhaft erkannt sind,
- bei Übereinstimmung der jeweiligen ersten Adreßteile (CADR1, RADR1) von fehlerhaften Speicherzellen wird die Adresse wenigstens einer der fehlerhaften Speicherzellen als Ergebnis der Funktionsüberprüfung zur Auswertung weiterverarbeitet, die Adressen weiterer fehlerhafter Speicherzellen werden nicht weiterverarbeitet.

2. Verfahren nach Anspruch 1,
**dadurch gekennzeichnet, daß**
innerhalb des Kreuzungsbereichs (K) die Speicherzellen (MC) nacheinander entlang von Spaltenleitungen (BL) oder Reihenleitungen (WL) geprüft werden.

3. Verfahren nach Anspruch 1 oder 2,
**dadurch gekennzeichnet, daß**
die Spaltenadressen (CADR) und Reihenadressen (RADR) der Speicherzellen jeweils einen zweiten Adreßteil (CADR2, RADR2) umfassen, über den die Speicherzellen (MC) innerhalb der jeweiligen Gruppe (C, R) adressierbar sind.

4. Verfahren nach Anspruch 3,
**dadurch gekennzeichnet, daß**
- zur Prüfung der Speicherzellen (MC) innerhalb des Kreuzungsbereichs (K) zuerst der zweite Adreßteil (CADR2) der Spaltenadresse und nach vollständiger Prüfung der betreffenden Reihenleitung der zweite Adreßteil (RADR2) der Reihenadresse inkrementiert wird,
- zur Ermittlung der als nächstes zu prüfenden Gruppe der erste Adreßteil (CADR1) der Spaltenadresse inkrementiert wird.

5. Verfahren nach Anspruch 3,
**dadurch gekennzeichnet, daß**
- zur Prüfung der Speicherzellen (MC) innerhalb des Kreuzungsbereichs (K) zuerst der zweite Adreßteil (CADR2) der Spaltenadresse und nach vollständiger Prüfung der betreffenden Reihenleitung der zweite Adreßteil (RADR2) der Reihenadresse inkrementiert wird,
- zur Ermittlung der als nächstes zu prüfenden Gruppe der erste Adreßteil (RADR1) der Reihenadresse inkrementiert wird.

6. Verfahren nach Anspruch 3,
**dadurch gekennzeichnet, daß**
- zur Prüfung der Speicherzellen (MC) innerhalb des Kreuzungsbereichs (K) zuerst der zweite Adreßteil (RADR2) der Reihenadresse und nach vollständiger Prüfung der betreffenden Spaltenleitung der zweite Adreßteil (CADR2) der Spaltenadresse inkrementiert wird,
- zur Ermittlung der als nächstes zu prüfenden Gruppe der erste Adreßteil (CADR1) der Spaltenadresse inkrementiert wird.

7. Verfahren nach Anspruch 3,
**dadurch gekennzeichnet, daß**
- zur Prüfung der Speicherzellen (MC) innerhalb des Kreuzungsbereichs (K) zuerst der zweite Adreßteil (RADR2) der Reihenadresse und nach vollständiger Prüfung der betreffenden Spaltenleitung der zweite Adreßteil (CADR2) der Spaltenadresse inkrementiert wird,
- zur Ermittlung der als nächstes zu prüfenden Gruppe der erste Adreßteil (RADR1) der Reihenadresse inkrementiert wird.

8. Verfahren nach einem der vorhergehenden Ansprüche,
**dadurch gekennzeichnet, daß**
die Speicherzellen (MC) jeweils zu Gruppen von Speicherzellen zusammengefaßt sind und die Gruppen von Speicherzellen nacheinander auf Fehlerfreiheit geprüft werden.

9. Integrierter Speicher, der einem Speicherzellentest unterziehbar ist zur Ermittlung von funktionsfähigen und fehlerhaften Speicherzellen,
- mit adressierbaren Speicherzellen (MC) in einem matrixförmigen Speicherzellenfeld (1), die entlang von Spaltenleitungen (BL) und Reihenleitungen (WL) angeordnet sind,
- bei dem die Speicherzellen (MC) zu Gruppen von Spaltenleitungen (C) und Reihenleitungen (R) zusammengefaßt sind und jeweils über Spaltenadressen (CADR) und Reihenadressen (RADR) adressierbar sind,
- bei dem die Spaltenadressen (CADR) und Reihenadressen (RADR) jeweils einen ersten Adreßteil (CADR1, RADR1) umfassen, über den die jeweiligen Gruppen von Spaltenleitungen (C) und Reihenleitungen (R) adressierbar sind, und einen zweiten Adreßteil (CADR2, RADR2), über den die Speicherzellen (MC) innerhalb der jeweiligen Gruppe (C, R) adressierbar sind,
- mit einem jeweiligen Zähler (11, 13) zur Generierung des ersten Adreßteils (CADR1, RADR1) und einem jeweiligen weiteren Zähler (12, 14) zur Generierung des zweiten Adreßteils (CADR2, RADR2), die jeweils Steuereingänge (L1; L4) aufweisen, die mit Ausgängen (A1; A4) einer Adressierungseinheit (2) verbunden sind,
- bei dem die jeweiligen Adreßteile (CADR1, RADR1, CADR2, RADR2) von zu prüfenden Speicherzellen ausgangsseitig an dem jeweiligen Zähler (11, 13, 12, 14) entnehmbar sind,
- bei dem die Adressierungseinheit (2) die Zähler zur Adressierung von zu prüfenden Speicherzellen derart ansteuert, daß die Speicherzellen im Kreuzungsbereich (K) einer der Gruppen von Spaltenleitungen (C) und einer der Gruppen von Reihenleitungen (R) nacheinander adressiert werden und im Anschluß daran Speicherzellen einer weiteren Gruppe von Spaltenleitungen (C) oder Reihenleitungen (R) adressiert werden.

10. Integrierter Speicher nach Anspruch 9,
**dadurch gekennzeichnet, daß**
der integrierte Speicher einen ersten Zähler (11) zur Generierung des ersten Adreßteils (RADR1) der Reihenadresse, einen zweiten Zähler (12) zur Generierung des zweiten Adreßteils (RADR2) der Reihenadresse, einen ditten Zähler (13) zur Generierung des ersten Adreßteils (CADR1) der Spaltenadresse und einen vierten Zähler (14) zur Generierung des zweiten Adreßteils (CADR2) der Spaltenadresse aufweist.

11. Integrierter Speicher nach Anspruch 9,
**dadurch gekennzeichnet, daß**
der integrierte Speicher einen ersten Zähler (15) zur Generierung des ersten Adreßteils (RADR1, CADR1) der Reihenadresse und Spaltenadresse und einen zweiten Zähler (16) zur Generierung des zweiten Adreßteils (RADR2, CADR2) der Reihenadresse und Spaltenadresse aufweist.

12. Integrierter Speicher nach einem der Ansprüche 9 bis 11,
**dadurch gekennzeichnet, daß**
die Zähler (11; 18) als lineare Zähler, Gray-Code-Zähler oder rückgekoppelte Schieberegister ausgebildet sind.

13. Integrierter Speicher nach einem der Ansprüche 9 bis 12,
**dadurch gekennzeichnet, daß**
die Adressierungseinheit (2) jeweils in einer von mehreren einstellbaren Betriebsarten betreibbar ist, die sich in der Adressierungsreihenfolge der zu prüfenden Speicherzellen unterscheiden.

14. Integrierter Speicher nach einem der Ansprüche 9 bis 13,
**dadurch gekennzeichnet, daß**
- die Adressierungseinheit (2) Steuereingänge zur Steuerung des Adressierungsvorgangs aufweist,
- die Steuereingänge der Adressierungseinheit (2) mit einer Selbsttesteinheit (3) verbunden sind.
